# EUROPÄISCHE PATENTSCHRIFT

(11) **EP 3 635 422 B1**
(45) Veröffentlichungstag und Bekanntmachung des Hinweises auf die Patenterteilung: **13.12.2023**
(21) Anmeldenummer: 18728852.7
(22) Anmeldetag: 29.05.2018
(51) Int. Cl.: G01R 31/36, H01M 10/44, H01M 10/48, H01M 10/42, G01R 31/387, G01R 31/389

(54) **BATTERIEMANAGEMENTSYSTEM FÜR EINEN LITHIUM-IONEN-AKKUMULATOR EINES ELEKTROGERÄTS UND VERFAHREN ZUM BETREIBEN EINES LITHIUM-IONEN-AKKUMULATORS EINES ELEKTROGERÄTS**
BATTERY MANAGEMENT SYSTEM FOR A LITHIUM ION BATTERY OF AN ELECTRICAL APPLIANCE AND METHOD FOR OPERATING A LITHIUM ION BATTERY OF AN ELECTRICAL APPLIANCE
SYSTÈME DE GESTION DE BATTERIE POUR UNE BATTERIE LITHIUM-ION D'UN APPAREIL ÉLECTRIQUE ET PROCÉDÉ DE FONCTIONNEMENT D'UNE BATTERIE LITHIUM-ION D'UN APPAREIL ÉLECTRIQUE

(30) Priorität: 06.06.2017 DE 102017112355
(43) Veröffentlichungstag der Anmeldung: 15.04.2020
(73) Patentinhaber: Einhell Germany AG, 94405 Landau / Isar (DE)
(72) Erfinder: THANNHUBER, Markus, 94405 Landau (DE)
(74) Vertreter: Hofstetter, Schurack & Partner
(86) Internationale Anmeldenummer: PCT/EP2018/064071
(87) Internationale Veröffentlichungsnummer: WO 2018/224358

(56) Entgegenhaltungen:
- DE-A1-102009 020 271
- DE-A1-102009 020 271
- DE-A1-102013 021 637
- DE-A1-102013 021 637
- DE-A1-102015 106 545
- DE-A1-102015 106 545

## Beschreibung

Die Erfindung betrifft ein Batteriemanagementsystem für einen Lithium-Ionen-Akkumulator eines Elektrogeräts und ein Verfahren zum Betreiben eines Lithiumlonen-Akkumulators eines Elektrogeräts. Ferner betrifft die Erfindung noch einen Lithium-Ionen-Akkumulator für ein Elektrogerät sowie ein Elektrogerät.

Elektrogeräte, wie beispielsweise elektrische Handwerkzeuge oder elektrische Gartengeräte, werden immer häufiger mittels Lithium-Ionen-Akkumulatoren mit der notwendigen Energie versorgt. Lithium erlaubt größte Zellspannungen in heute üblichen technischen Konfigurationen von bis zu 3,6 V. Energie zu versorgen.

Grundsätzlich gibt es eine Vielzahl von Lithium-Ionen-Zellen, jedoch sind nur wenige dieser Zellen für Elektrogeräte geeignet, welche kurzzeitig sehr hohe Stromanforderungen aufweisen. Dies ist insbesondere bei elektrisch betriebenen Handwerkzeugen oder elektrisch betriebenen Gartengeräten der Fall. Daher werden Lithium-Ionen-Akkumulatoren üblicherweise bei Anwendungen verwendet, bei welchen es vor allem auf besonders lange Laufzeiten aber nicht auf die Bedienung von besonders hohen Stromanforderungen in Form von Stromspitzen ankommt. Lithium-Ionen-Akkumulatoren sind klassischerweise besonders gut geeignet für elektronische Geräte, wie beispielsweise Notebooks, Camcorder, Handys und dergleichen. All diese Geräte sind dadurch gekennzeichnet, dass sie vor allem besonders lange laufen sollen, ohne dass dabei besonders hohe Lasten und somit Stromspitzen auftauchen.

Im Vergleich zu elektrischen Handwerkzeugen und elektrischen Gartengeräten zeichnen sich solche elektronischen Geräte dadurch aus, dass die Stromanforderungen relativ niedrig und sehr gleichmäßig sind. Elektrische Handwerkzeuge und elektrische Gartengeräte sollen hingegen besonders leistungsfähig sein und benötigen eine entsprechende Strom- bzw. Energieversorgung durch entsprechend dafür geeignete Lithium-Ionen-Akkumulatoren. Die Stromanforderungen von elektrischen Handwerkzeugen und elektrischen Gartengeräten ist üblicherweise gekennzeichnet durch eine besonders hohe mittlere Stromaufnahme und durch vereinzelt besonders sehr hohe Stromspitzen.

Die auftretenden Stromspitzen bei elektrischen Handwerkzeugen und elektrischen Gartengeräten sind teilweise bis zu 100-mal höher als bei herkömmlichen elektronischen Geräten, wie beispielsweise Handys und dergleichen. Für elektrische Handwerkzeuge und elektrische Gartengeräte sind die hohen Kapazitäten der Lithium-Ionen-Akkumulatoren zunächst zwar sehr schön, aber die Kapazität ist hier nicht der eigentlich limitierende Faktor. Hier ist es die Leistungsfähigkeit, also die Leistungsabgabe in Watt. Beim Arbeiten mit einer Handkreissäge oder mit einem Winkelschleifer benötigt man im Moment des Schneidens bzw. im Moment des Schleifens enorme Leistungen. Die Batterien müssen sich hier innerhalb kürzester Zeit entladen können. Wichtig ist es auch, dass das Wiederaufladen von Lithium-Ionen-Akkumulatoren im Zusammenhang mit elektrischen Handwerkzeugen oder elektrischen Gartengeräten schnell vonstattengeht, sodass beispielsweise mit nur zwei Akkupacks auf Lithium-Ionen-Basis im Wesentlichen kontinuierlich gearbeitet werden kann, indem wechselweise die zwei Akkupacks entladen und aufgeladen werden.

Die DE 10 2013 021 637 A1 zeigt ein Batteriesystem mit mehreren Batteriezellen. Ein Teil der Batteriezellen sind Leistungszellen, die eine hohe maximal abgebbare Stromstärke und eine vergleichsweise geringe Kapazität aufweisen. Ein anderer Teil der Batteriezellen sind Energiezellen, die im Hinblick auf eine maximale Energiedichte entwickelt wurden und eine Grundlast eines Verbrauchers, beispielsweise eines elektrisch angetriebenen Kraftfahrzeugs, decken sollen, während die Leistungszellen für Spitzenlasten vorbehalten sind. Bei den Leistungszellen kann es sich um Lithium-Ionen-Zellen oder Kondensatoren handeln, wobei es sich bei den Energiezellen um bleibasierte Zellen handeln kann.

Die DE 10 2009 020 271 A1 zeigt einen Energiespeicher mit elektrochemischer Akkumulatorfunktion und integrierter Kondensatorfunktion. Durch Erzeugen von zusätzlichen Doppelschichten mittels Vergrößerung der Grenzfläche zwischen Elektrolyt und Elektrodenmaterialien wird ein integral parallel zu jeweiligen Batteriezellen geschalteter Doppelschichtkondensator erzielt.

Es ist daher die Aufgabe der vorliegenden Erfindung, eine Lösung bereitzustellen, mittels welcher Elektrogeräte mit besonders hohen Stromanforderungen und insbesondere mit hohen Stromspitzen zuverlässig mittels Lithium-Ionen-Akkumulatoren mit Energie versorgt werden können.

Diese Aufgabe wird durch ein Batteriemanagementsystem für einen Lithium-Ionen-Akkumulator sowie durch ein Verfahren zum Betreiben eines Lithium-Ionen-Akkumulators mit den Merkmalen der unabhängigen Patentansprüche gelöst. Vorteilhafte Ausgestaltungen mit zweckmäßigen und nicht trivialen Weiterbildungen der Erfindung sind in den abhängigen Ansprüchen angegeben.

Das erfindungsgemäße Batteriemanagementsystem für einen Lithium-Ionen-Akkumulator eines Elektrogeräts, insbesondere eines elektrischen Handwerkzeugs oder elektrischen Gartengeräts, ist dazu eingerichtet, eine Differenz zwischen einer Stromanforderung des Elektrogeräts und eines vorgegebenen Bemessungsstroms, welcher mittels des Lithium-Ionen-Akkumulators elektrochemisch bereitstellbar ist, zu bestimmen. Des Weiteren ist das erfindungsgemäße Batteriemanagementsystem dazu eingerichtet, die Differenz unter Ausnutzung einer dielektrischen Kapazität des Lithium-Ionen-Akkumulators insoweit abzudecken, wie dadurch vorgegebene zulässige Betriebszustände des Lithium-Ionen-Akkumulators nicht verlassen werden, gemäß dem unabhängigen Anspruch 1.

Der Erfindung liegt dabei die Erkenntnis zugrunde, dass Elektrogeräte, insbesondere elektrische Handwerkzeuge oder elektrische Gartengeräte, durchaus besondere Stromanforderungen mit hohen Stromspitzen aufweisen können. Die Besonderheit solcher Elektrogeräte liegt darin, dass kurzzeitig sehr hohe Stromspitzen durch eingesetzte Lithium-Ionen-Akkumulatoren abgedeckt werden müssen. Diese hohen Stromspitzen sind bedingt dadurch, dass diese Elektrogeräte elektromotorische Applikationen darstellen, bei denen Massen auf hohe Drehzahlen und hohe Geschwindigkeiten beschleunigt bzw. abgebremst werden. Dabei wirken enorme Kräfte und Drehmomente. Diese treten zudem in unvorhersehbarer und oftmals undefinierter Weise auf. Sei es bei einer Akkusäge z.B. ein Nagel im Brett, bei einem Akkurasenmäher z.B. ein Stein im Gras, bei einem Akkufräser z.B. ein Span, der sich zwischen Werkstück und Werkzeug befindet und das Werkzeug sperrt oder dergleichen. Schon das Anfahren und Bremsen eines solchen Elektrogeräts führt zu einem enormen und spontanen Leistungsbedarf. Die Diffusions- und Reaktionsgeschwindigkeiten in Lithium-Ionen-Akkumulatoren reichen zur Abdeckung solcher extremen Stromanforderungen schlichtweg nicht aus.

Der Erfindung liegt in diesem Zusammenhang die Erkenntnis zugrunde, dass sich Lithium-Ionen-Akkumulatoren zudem ganz ähnlich wie Doppelschichtkondensatoren verhalten. Die Lithium-Ionen-Zelle ist faktisch ein kleiner Kondensator. Zugute kommt den Lithium-Ionen-Zellen ein ganz besonderer Effekt: An den Grenzflächen zwischen Elektrolyt und insbesondere der Anode kommt es zur Ladungstrennung, in Form eines lonenstaus. Dabei stehen sich die Ladungen unterschiedlicher Polarität in kleinstem Abstand gegenüber. Dies entspricht dem Aufbau eines Doppelschichtkondensators. Doppelschichtkondensator zeichnen sich durch eine besonders hohe Kapazität aus. Die Elektrochemie der Lithium-Ionen-Zelle entwickelt bei geeigneter Ausführung somit einen potenten dielektrischen Effekt in Form einer besonders hohen vorliegenden dielektrischen Kapazität. Genau dieser Effekt ist notwendig, um Elektrogeräte, wie elektrische Handwerkzeuge oder elektrische Gartengeräte, mit besonders hohen Stromanforderungen und hohen Spitzenströmen qualitativ hochwertig betreiben zu können. Mittels des erfindungsgemäßen Batteriemanagementsystems ist es möglich, insbesondere besonders hohe Stromspitzen und an sich hohe Stromanforderungen, welche über einem vorgegebenen Bemessungsstrom, welcher mittels des Lithium-Ionen-Akkumulators elektrochemisch bereitstellbar ist, abzudecken.

Mittels des erfindungsgemäßen Batteriemanagementsystems ist es möglich, den systeminhärenten dielektrischen Effekt von Lithium-Ionen-Akkumulatoren in Form der vorliegenden dielektrischen Kapazität bedarfsgerecht und gleichzeitig sicher zu nutzen.

Das Batteriemanagementsystem ist dazu in der Lage, anhand einer vorliegenden Stromanforderung des Elektrogeräts, welches beispielsweise mittels eines Motorsteuergeräts bereitgestellt wird, zu ermitteln. Zudem kann das Batteriemanagementsystem ermitteln, zu welchem Anteil diese Stromanforderung überhaupt elektrochemisch mittels des Lithium-Ionen-Akkumulators bereitgestellt werden kann. Mit anderen Worten kann das Batteriemanagementsystem also gegebenenfalls eine vorhandene Diskrepanz zwischen der bestehenden Stromanforderung und der rein elektrochemisch lieferbaren Energie durch den Lithium-Ionen-Akkumulator bestimmen. Das Batteriemanagementsystem ist dazu eingerichtet, diese Differenz unter Ausnutzung der dielektrischen Kapazität des Lithium-Ionen-Akkumulators insoweit abzudecken, wie dadurch vorgegebene zulässige Betriebszustände des Lithium-Ionen-Akkumulators nicht verlassen werden. Jeweilige dielektrische Kapazitäten der einzelnen Zellen des Lithium-Ionen-Akkumulators können also bei Bedarf mittels des Batteriemanagementsystems dazu verwendet werden, Stromanforderungen des Elektrogeräts zu decken, die an sich aufgrund des elektrochemischen Metabolismus des Lithium-Ionen-Akkumulators sonst nicht bedient werden könnten. Der elektrochemisch bereitstellbare Strom bzw. die elektrochemisch pro Zeiteinheit bereitstellbare Ladungsmenge wird bestimmt durch Diffusionsvorgänge, Beschleunigungen und durch abstoßende oder anziehende Kräfte im Potenzialfeld des Lithium-Ionen-Akkumulators. Ferner bestimmen die maximal möglichen Reaktionsgeschwindigkeiten im Lithium-Ionen-Akkumulator, inwiefern dieser vorhandenen Stromanforderungen rein elektrochemisch nachkommen kann.

Eine etwa vorhandene Differenz zwischen einer Stromanforderung des Elektrogeräts und dem besagten Bemessungsstrom bedeutet, dass das Elektrogerät an sich mehr Strom benötigt, als der Lithium-Ionen-Akkumulator aufgrund seiner normalen Zellchemie im bestimmungsgemäßen Betrieb überhaupt bereitstellen kann. Hier greift das erfindungsgemäße Batteriemanagementsystem ein, indem es diese Differenz unter Ausnutzung der dielektrischen Kapazität des Lithium-Ionen-Akkumulators insoweit abdeckt bzw. bereitstellt, wie dadurch vorgegebene zulässige Betriebszustände des Lithium-Ionen-Akkumulators nicht verlassen werden. Dadurch ist es mittels des Batteriemanagementsystems möglich, Lithium-Ionen-Akkumulatoren derart zu betreiben, dass diese besonders hohe Stromanforderungen, insbesondere besonders hohe Stromspitzen, bedarfsgerecht und zugleich besonders sicher bedienen können.

Dadurch kann zum einen eine Überforderung der dielektrischen Kapazitäten innerhalb des Lithium-Ionen-Akkumulators verhindert werden. Das Zustandekommen von inhomogenen Strompfaden in den Elektroden des Lithium-Ionen-Akkumulators mit damit einhergehenden lokalen thermischen Überlastungen kann dadurch zuverlässig verhindert werden. Ebenso kann eine Überreizung des elektrochemischen Metabolismus des Lithium-Ionen-Akkumulators mittels des erfindungsgemäßen Batteriemanagementsystems zuverlässig verhindert werden.

Mittels des erfindungsgemäßen Batteriemanagementsystems ist es also möglich, die Potenziale von Lithium-Ionen-Akkumulatoren im Hinblick auf ihre dielektrischen Kapazitäten optimal auszunutzen, um besonders hohe Stromanforderungen von Elektrogeräten bedarfsgerecht und sicher zu bedienen.

Eine vorteilhafte Ausführungsform der Erfindung der sieht vor, dass das Batteriemanagementsystem dazu ausgelegt ist, unter Berücksichtigung eines aktuellen Ladezustands der dielektrischen Kapazität des Lithium-Ionen-Akkumulators die Differenz abzudecken. Das Batteriemanagementsystem ist also dazu in der Lage, jeweils aktuelle Ladezustände der dielektrischen Kapazität des Lithium-Ionen-Akkumulators zu erfassen und zu berücksichtigen. Wurde die dielektrische Kapazität des Lithium-Ionen-Akkumulators beispielsweise gerade in großen Teilen aufgebraucht, so kann dies das Batteriemanagementsystem erkennen. In Folge dessen kann sichergestellt werden, dass das Batteriemanagementsystem die dielektrische Kapazität des Lithium-Ionen-Akkumulators nicht über die Maßen heranzieht, um die besagte Differenz zwischen der Stromanforderung des Elektrogeräts und des vorgegebenen Bemessungsstroms, welcher mittels des Lithium-Ionen-Akkumulators elektrochemisch bereitstellbar ist, zu bedienen.

Eine weitere vorteilhafte Ausführungsform der Erfindung sieht vor, dass das Batteriemanagementsystem dazu ausgelegt ist, unter Berücksichtigung eines Aufladeverhaltens der dielektrischen Kapazität des Lithium-Ionen-Akkumulators die Differenz abzudecken. Das Batteriemanagementsystem kann also berücksichtigen, wie schnell oder wie langsam die dielektrische Kapazität des betreffenden Lithium-Ionen-Akkumulators wieder aufgeladen werden kann. Dadurch kann ebenfalls die dielektrische Kapazität des Lithium-Ionen-Akkumulators besonders gut genutzt werden.

Es ist erfindungsgemäß vorgesehen, dass das Batteriemanagementsystem dazu ausgelegt ist, anhand der Stromanforderung unterschiedliche Arten von Stromspitzen zu erkennen und in Abhängigkeit davon die dielektrische Kapazität des Lithium-Ionen-Akkumulators zum Abdecken der Differenz zwischen der Stromanforderung des Elektrogeräts und des vorgegebenen Bemessungsstroms zu nutzen. Mit anderen Worten kann das Batteriemanagementsystem also eine Art Stromprofiling vornehmen. Stromspitzen können bestimmte Stromverläufe über der Zeit sein, wobei die Stromstärke über dem gesamten Verlauf der jeweiligen Stromspitzen oberhalb von dem Bemessungsstrom liegt. Vorzugsweise ist das Batteriemanagementsystem dazu ausgelegt, vorgegebene Stromverläufe für die unterschiedlichen Arten von Stromspitzen mit der Stromanforderung zu vergleichen und basierend darauf die jeweiligen Arten von Stromspitzen zu erkennen. Beispielsweise können Stromprofile für verschiedene Ereignisse hinterlegt werden. Solche Ereignisse können beispielsweise das Anlaufen Träger Massen des Elektrogeräts, bestimmte Arbeitsimpulse, Werkstoffinhomogenitäten und dergleichen betreffen. Durch einen Abgleich der gerade vorliegenden Stromanforderung mit diesen hinterlegten Stromverläufen kann das Batteriemanagementsystem erkennen, mit was für einer Art von Stromspitze und einer entsprechenden Ausprägung des Stromverlaufs über der Zeit zu rechnen ist. Basierend darauf kann das Batteriemanagementsystem die dielektrische Kapazität des Lithium-Ionen-Akkumulators optimal zum Abdecken der Differenz zwischen der Stromanforderung des Elektrogeräts und des vorgegebenen Bemessungsstroms nutzen.

In weiterer vorteilhafter Ausgestaltung der Erfindung ist es vorgesehen, dass das Batteriemanagementsystem dazu ausgelegt ist, in Abhängigkeit von zumindest einer der folgenden Größen die Ausnutzung der dielektrischen Kapazität des Lithiumlonen-Akkumulators zu steuern:
- einer Temperatur des Lithium-Ionen-Akkumulators, insbesondere jeweiliger Zellen des Lithium-Ionen-Akkumulators;
- einem Innenwiderstand des Lithium-Ionen-Akkumulators, insbesondere von jeweiligen Zellen des Lithium-Ionen-Akkumulators;
- eines Ladezustands des Lithium-Ionen-Akkumulators, insbesondere von jeweiligen Zellen des Lithium-Ionen-Akkumulators;
- eines Gesundheitszustands, üblicherweise mit State of Health bezeichnet, des Lithium-Ionen-Akkumulators, insbesondere von jeweiligen Zellen des Lithium-Ionen-Akkumulators.

All diese genannten Größen sind dazu geeignet, vorgegebene zulässige Betriebszustände des Lithium-Ionen-Akkumulators zu bestimmen, sodass das Batteriemanagement unter Berücksichtigung von einer oder aller dieser Größen die dielektrische Kapazität des Lithium-Ionen-Akkumulators so nutzen kann, dass der Lithium-Ionen-Akkumulator dadurch nicht geschädigt wird.

Der erfindungsgemäße Lithium-Ionen-Akkumulator für ein Elektrogerät, insbesondere für ein elektrisches Handwerkzeug oder ein elektrisches Gartengerät, umfasst das erfindungsgemäße Batteriemanagementsystem oder eine vorteilhafte Ausführungsform des erfindungsgemäßen Batteriemanagementsystems.

Das erfindungsgemäße Elektrogerät, insbesondere in Form eines elektrischen Handwerkzeugs oder elektrischen Gartengeräts, umfasst den erfindungsgemäßen Lithium-Ionen-Akkumulator mit dem besagten Batteriemanagementsystem. Bei dem Elektrogerät kann es sich beispielsweise um akkubetriebene Schrauber, Bohrmaschinen, Bohrhämmer, Sägen, Schleifmaschinen und dergleichen handeln. Zudem kann es sich bei dem Elektrogerät auch beispielsweise auch um akkubetriebene Gartengeräte in Form von Rasenmähern, Vertikutierern, Heckenscheren, Kettensägen und dergleichen handeln.

Bei dem erfindungsgemäßen Verfahren zum Betreiben eines Lithium-Ionen-Akkumulators eines Elektrogeräts, insbesondere eines elektrischen Handwerkzeugs oder elektrischen Gartengeräts wird mittels des erfindungsgemäßen Batteriemanagementsystems oder einer vorteilhaften Ausführungsform des erfindungsgemäßen Batteriemanagementsystems eine Differenz zwischen einer Stromanforderung des Elektrogeräts und eines vorgegebenen Bemessungsstroms, welcher mittels des Lithium-Ionen-Akkumulator elektrochemisch bereitstellbar ist, bestimmt und die Differenz unter Ausnutzung einer dielektrischen Kapazität des Lithium-Ionen-Akkumulators insoweit abgedeckt, wie dadurch vorgegebene zulässige Betriebszustände des Lithium-Ionen-Akkumulators nicht verlassen werden. Das Batteriemanagementsystem erkennt anhand der Stromanforderung unterschiedliche Arten von Stromspitzen und nutzt in Abhängigkeit davon die dielektrische Kapazität des Lithium-Ionen-Akkumulators zum Abdecken der Differenz zwischen der Stromanforderung des Elektrogeräts und des vorgegebenen Bemessungsstroms. Vorteilhafte Ausgestaltungen des erfindungsgemäßen Batteriemanagementsystems sind als vorteilhafte Ausgestaltungen des erfindungsgemäßen Verfahrens und umgekehrt anzusehen, wobei das Batteriemanagementsystem insbesondere Mittel zur Durchführung der Verfahrensschritte aufweist.

Weitere Vorteile, Merkmale und Einzelheiten der Erfindung ergeben sich aus der nachfolgenden Beschreibung eines bevorzugten Ausführungsbeispiels sowie anhand der Zeichnung. Die vorstehend in der Beschreibung genannten Merkmale und Merkmalskombinationen sowie die nachfolgend in der Figurenbeschreibung und/oder in den Figuren alleine gezeigten Merkmale und Merkmalskombinationen sind nicht nur in der angegebenen Kombination, sondern auch in anderen Kombinationen oder in Alleinstellung verwendbar, ohne den Rahmen der Erfindung zu verlassen.

Die Zeichnung zeigt in:
- Fig. 1: eine Perspektivansicht eines Akku-Bohrschraubers mit einem austauschbaren Lithium-Ionen-Akkumulator, welcher an der Unterseite des Akku-Bohrschraubers angebracht ist;
- Fig. 2: eine schematische Darstellung einer von vielen Batteriezellen des Lithium-Ionen-Akkumulators, wobei zudem schematisch ein Batteriemanagementsystem zum Steuern des Lithium-Ionen-Akkumulators dargestellt ist;
- Fig. 3: eine vergrößerte schematische Darstellung eines Ausschnitts der Batteriezelle, wobei eine passive Grenzschicht an einer Grenzfläche zwischen einer Anode und einem Elektrolyt dargestellt ist, wo es aufgrund eines lonenstaus zur Ausbildung einer dielektrischen Kapazität kommt; und in
- Fig. 4: eine schematische Darstellung eines Stromprofils mit verschiedenen Stromspitzen, welche beim Betrieb des Akku-Bohrschraubers auftreten können.

In den Figuren sind gleiche oder funktionsgleiche Elemente mit den gleichen Bezugszeichen versehen worden.

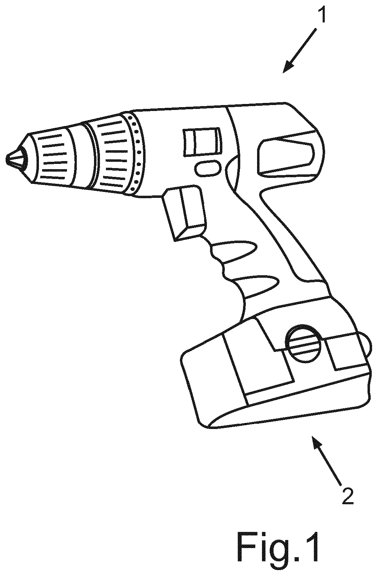

Ein Akku-Bohrschrauber 1 ist in einer Perspektivansicht in Fig. 1 gezeigt. An der Unterseite des Akku-Bohrschraubers 1 ist ein Lithium-Ionen-Akkumulator 2 in Form eines austauschbaren Akkupacks angebracht. Nachfolgend wird beispielhaft für den Akku-Bohrschrauber beschrieben, wie ein solcher Lithium-Ionen-Akkumulator 2 bestmöglich betrieben werden kann, um die Stromanforderung des Akku-Bohrschraubers 1 zu erfüllen. Die nachfolgenden Erläuterungen sind nur beispielhaft für den Akku-Bohrschrauber 1 zu verstehen. Sie gelten genauso für sämtliche Elektrogeräte mit hohen Stromanforderungen, bei welchen insbesondere hohe Stromspitzen auftreten. Der Akku-Bohrschrauber steht somit stellvertretend für verschiedenste elektrische Handwerkzeuge oder elektrische Gartengeräte, wie beispielsweise akkubetriebene Bohrmaschinen, Fräsmaschinen, Schleifmaschinen, Rasenmäher, Vertikutierer, Kettensägen und dergleichen, welche alle mittels Lithiumlonen-Akkumulatoren betrieben werden.

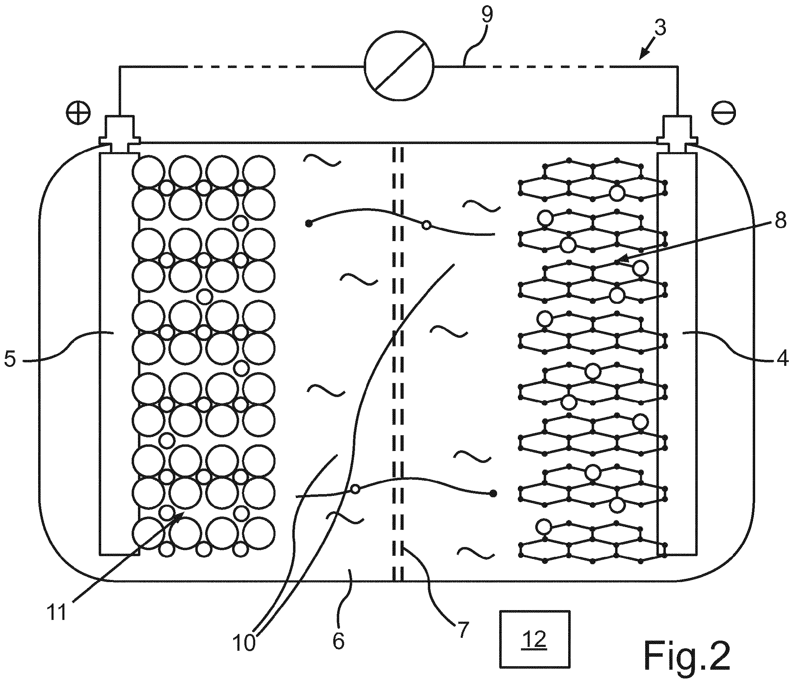

In Fig. 2 ist eine Batteriezelle 3 des Lithium-Ionen-Akkumulators 2 schematisch dargestellt. Die Batteriezelle 3 umfasst eine Anode 4 und eine Kathode 5, welche in eine nicht-wässrige Elektrolytlösung 6 getaucht sind. Die Anode 4 und die Kathode 5 sind dabei durch einen Separator 7 getrennt. Die Anode 4 umfasst zudem eine Graphit-Interkalationsverbindung 8, wobei Lithium als Kation vorliegt. Beim Entladen gibt die Graphit-Interkalationsverbindung 8 Elektronen ab, die über einen externen Stromkreis 9 zur Kathode 5 fließen. Gleichzeitig wandern gleich viele Lithium-Ionen 10 aus der Interkalationsverbindung 8 durch den Elektrolyten 6 zur Kathode 5. An der Kathode 5 nehmen nicht die Lithium-Ionen 10 die Elektronen des externen Stromkreises 9 auf, sondern die dort vorhandenen Strukturen von Übergangsmetallverbindungen 11.

Zudem ist in Fig. 2 noch ein Batteriemanagementsystem 12 schematisch angedeutet, welches zur Überwachung und Regelung der Batteriezellen 3, und somit des Lithium-Ionen-Akkumulators 2, dient. Bei dem Batteriemanagementsystem 12 kann es sich beispielsweise um eine elektronische Schaltung handeln, welche auch eine umfangreiche Leistungselektronik aufweisen kann.

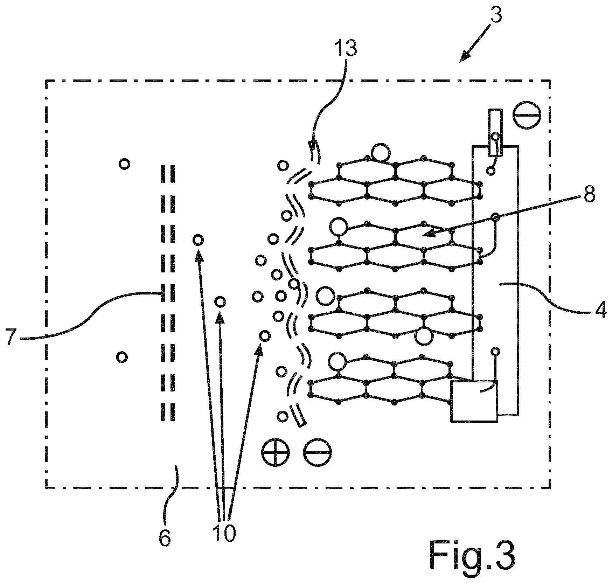

In Fig. 3 ist ein Ausschnitt der Batteriezelle 3 dargestellt, wobei eine passive Grenzschicht 13 schematisch dargestellt ist, die sich an einer nicht näher bezeichneten Grenzfläche zwischen der Anode 4 und dem Elektrolyt 6 gebildet hat, die durch die Zersetzung des Elektrolyts 6 entsteht. Diese passive Grenzschicht 13 wird üblicherweise auch als Solid Elektrolyte Interface, kurz SEI, bezeichnet.

Im Bereich dieser passiven Grenzschicht 13 bildet sich durch eine Art lonenstau eine dielektrische Kapazität innerhalb der jeweiligen Batteriezellen 3 aus. Diese dielektrische Kapazität ist von ihrer Funktionsweise und von ihren Eigenschaften her mit der eines Doppelschichtkondensators vergleichbar.

An der passiven Grenzschicht 13 kommt es zur Ladungstrennung aufgrund eines lonenstaus. An dieser passiven Grenzschicht 13 stehen sich Ladungen unterschiedlicher Polarität in geringstem Abstand gegenüber. Wie bei einem Doppelschichtkondensator zeichnet sich die im Bereich der passiven Grenzschicht 13 ausgebildete dielektrische Kapazität durch eine besonders hohe Kapazität aus. Das in Fig. 2 schematisch angedeutete Batteriemanagementsystem 12 macht sich diese systeminhärente Eigenschaft des Lithium-Ionen-Akkumulators 2 zu nutze.

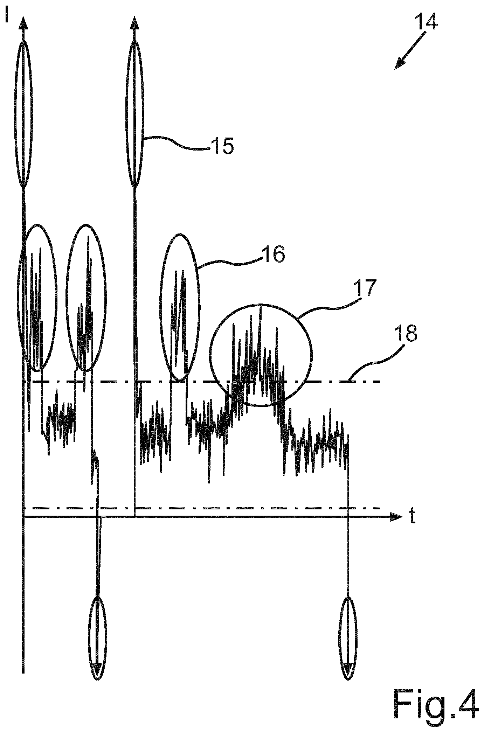

In Fig. 4 ist eine Stromanforderung 14 in Form eines Stromprofils für den Akku-Bohrschrauber 1 schematisch angedeutet. Die Stromanforderung 14 des Akku-Bohrschraubers 1 ist also als Stromverlauf I über der Zeit t aufgetragen. Innerhalb des Diagramms sind für die Stromanforderung 14 unterschiedliche Arten von Stromspitzen 15, 16, 17 beispielhaft gekennzeichnet. Die Stromspitze 15 beispielsweise fällt besonders abrupt und bezüglich des Stroms besonders hoch aus. Die Stromspitzen 16, 17 fallen etwas geringer aus, verbleiben jedoch länger auf einem relativ hohen Wert. In dem Diagramm ist zudem ein vorgegebener Bemessungsstrom 18 gekennzeichnet, welcher mittels des Lithium-Ionen-Akkumulators 2 elektrochemisch aufgrund seines elektrochemischen Metabolismus bereitstellbar ist. Der Bemessungsstrom 18 wird durch Diffusionsvorgänge, Beschleunigungen, durch abstoßende oder anziehende Kräfte im Potenzialfeld der Batteriezellen 3 und der Reaktionsgeschwindigkeiten in den Batteriezellen 3 bestimmt.

Wie zu erkennen, ist die Stromanforderung 14 durch sehr abrupte und heftige Ausschläge bezüglich des Stroms I gekennzeichnet. Rein elektrochemisch wäre der Lithium-Ionen-Akkumulator 2 aufgrund seines relativ langsamen elektrochemischen Metabolismus gar nicht in der Lage, die Stromanforderung 14 im Hinblick auf die verschiedenen Stromspitzen 15, 16, 17 zu erfüllen. An dieser Stelle kommt die zuvor beschriebene dielektrische Kapazität, welche aufgrund des lonenstaus im Bereich der passiven Grenzschicht 13 entsteht, zum Einsatz.

Das Batteriemanagementsystem 12 ist dazu eingerichtet, eine Differenz zwischen der hier gezeigten Stromanforderung 14 des Akku-Bohrschraubers 1 und des vorgegebenen Bemessungsstroms 18, welcher mittels des Lithium-Ionen-Akkumulators 2 rein elektrochemisch bereitstellbar ist, zu bestimmen. Diese bestimmte Differenz kann das Batteriemanagementsystem 12 unter Ausnutzung der besagten dielektrischen Kapazität des Lithium-Ionen-Akkumulators 2 insoweit abdecken, wie dadurch vorgegebene zulässige Betriebszustände des Lithium-Ionen-Akkumulators 2 nicht verlassen werden. Die Stromspitzen 15, 16, 17 können daher mittels des Lithium-Ionen-Akkumulators 2 durch eine geschickte Ansteuerung durch das Batteriemanagementsystem 12 vollständig oder zumindest teilweise bedient werden, obwohl der langsame elektrochemische Metabolismus der Batteriezellen 3 an sich gar nicht dazu in der Lage wäre.

Das Batteriemanagementsystem 12 ist dabei in der Lage, durch ein besonders schnelles Stromprofiling die verschiedenen Stromspitzen 15, 16, 17 zu berücksichtigen. Das Batteriemanagementsystem 12 kann also die unterschiedlichen Arten der Stromspitzen 15, 16, 17 erkennen und in Abhängigkeit davon die dielektrische Kapazität des Lithium-Ionen-Akkumulators 2 zum Abdecken der Differenz zwischen der Stromanforderung 14 des Akku-Bohrschraubers 1 und des vorgegebenen Bemessungsstroms 18 nutzen. Beispielsweise können vorgegebene Stromverläufe für die unterschiedlichen Arten von Stromspitzen 15, 16, 17 auf einem Datenträger gespeichert und dem Batteriemanagementsystem 12 bereitgestellt werden. Das Batteriemanagementsystem 12 ist in der Lage, die Stromanforderung 14 über dem Zeitverlauf mit diesen vorgegebenen Stromverläufen zu vergleichen um basierend darauf die jeweiligen Arten der Stromspitzen 15, 16, 17 besonders schnell zu erkennen. Das Batteriemanagementsystem 12 ist dadurch in der Lage, die auftretenden Stromspitzen 15, 16, 17 besonders schnell unter Ausnutzung der dielektrischen Kapazität des Lithium-Ionen-Akkumulators 2 zu bedienen.

Das Batteriemanagementsystem 12 ist zudem dazu ausgelegt, unter Berücksichtigung eines aktuellen Ladezustands der dielektrischen Kapazität des Lithium-Ionen-Akkumulators 2, also sämtlicher dielektrischen Kapazitäten der einzelnen Batteriezellen 3, die besagte Differenz zwischen der aktuellen Stromanforderung 14 und des Bemessungsstroms 18 abzudecken. Ferner kann das Batteriemanagementsystem 12 auch ein Aufladeverhalten der dielektrischen Kapazität des Lithium-Ionen-Akkumulators 2 bei der Abdeckung der besagten Differenz zwischen der Stromanforderung 14 und des Bemessungsstroms 18 berücksichtigen. Das Batteriemanagementsystem 12 ist also in der Lage, die Eigenschaften des Lithium-Ionen-Akkumulators 2 im Hinblick auf seine dielektrische Kapazität so auszureizen, dass die Stromanforderung 14 besonders bedarfsgerecht und zudem auch sicher erfüllt werden kann.

Ferner kann das Batteriemanagementsystem 12 auch verschiedenste Größen des Lithium-Ionen-Akkumulators 2 bei der Ausnutzung der dielektrischen Kapazität berücksichtigen. Beispielsweise kann das Batteriemanagementsystem 12 Temperaturen innerhalb der einzelnen Batteriezellen 3, Innenwiderstände in den Batteriezellen 3, Ladezustände der einzelnen Batteriezellen 3 oder auch jeweilige Gesundheitszustände, den sogenannten State of Health, der jeweiligen Batteriezellen 3 berücksichtigen. Ferner können beispielsweise in einem Kennfeld in Abhängigkeit von verschiedensten Umgebungsrandbedingungen, wie beispielsweise der Umgebungstemperatur und dergleichen, zulässige Betriebszustände des Lithium-Ionen-Akkumulators 2 definiert sein, welche das Batteriemanagementsystem 12 ebenfalls berücksichtigt, wenn dieses die dielektrische Kapazität des Lithium-Ionen-Akkumulators 2 nutzt, um so gut wie möglich die verschiedenen Stromspitzen 15, 16, 17 während der Verwendung des Akku-Bohrschraubers 1 energetisch abzudecken.

Die systeminhärenten dielektrischen Effekte des Lithium-Ionen-Akkumulators 2 werden also durch das geschickte Batteriemanagementsystem 12 ideal ausgenutzt, und zwar in dem Sinne, dass hohe Stromspitzen 15, 16, 17 trotz des vergleichsweise langsamen elektrochemischen Metabolismus des Lithium-Ionen-Akkumulators 2 abgedeckt werden können, und zwar ohne den Lithium-Ionen-Akkumulator 2 zu schädigen.

### BEZUGSZEICHENLISTE:

- 1: Akku-Bohrschrauber
- 2: Lithium-Ionen-Akkumulator
- 3: Batteriezelle
- 4: Anode
- 5: Kathode
- 6: nicht-wässrige Elektrolytlösung
- 7: Separator
- 8: Graphit-Interkalationsverbindung
- 9: externer Stromkreis
- 10: Lithium-Ionen
- 11: Übergangsmetallverbindung
- 12: Batteriemanagementsystem
- 13: passive Grenzschicht
- 14: Stromanforderung
- 15: Stromspitze
- 16: Stromspitze
- 17: Stromspitze
- 18: Bemessungsstrom
- I: Strom
- t: Zeit

## Patentansprüche

1. Batteriemanagementsystem (12) für einen Lithium-Ionen-Akkumulator (2) eines Elektrogeräts (1), insbesondere eines elektrischen Handwerkzeugs oder elektrischen Gartengeräts, welches dazu eingerichtet ist,
- eine Differenz zwischen einer Stromanforderung (14) und eines vorgegebenen Bemessungsstroms (18), welcher einer mittels des Lithium-Ionen-Akkumulators (2) pro Zeiteinheit auf Grund seiner maximal möglichen Reaktionsgeschwindigkeit elektrochemisch bereitstellbaren Landungsmenge entspricht, zu bestimmen;
- einen Ausgangsstrom des Lithium-Ionen-Akkumulators (2) derart zu steuern, dass die Differenz unter Ausnutzung einer dielektrischen Kapazität des Lithium-Ionen-Akkumulators (2) insoweit abgedeckt wird, wie dadurch vorgegebene zulässige Betriebszustände des Lithium-Ionen-Akkumulators (2) nicht verlassen werden.

2. Batteriemanagementsystem (12) nach Anspruch 1,
**dadurch gekennzeichnet, dass**
das Batteriemanagementsystem (12) dazu ausgelegt ist, unter Berücksichtigung eines aktuellen Ladungszustands der dielektrischen Kapazität des Lithium-Ionen-Akkumulators (2) die Differenz abzudecken.

3. Batteriemanagementsystem (12) nach Anspruch 1 oder 2,
**dadurch gekennzeichnet, dass**
das Batteriemanagementsystem (12) dazu ausgelegt ist, unter Berücksichtigung eines Aufladeverhaltens der dielektrischen Kapazität des Lithium-Ionen-Akkumulators (2) die Differenz abzudecken.

4. Batteriemanagementsystem (12) nach einem der vorhergehenden Ansprüche,
**dadurch gekennzeichnet, dass**
das Batteriemanagementsystem (12) dazu ausgelegt ist, anhand der Stromanforderung (14) unterschiedliche Arten von Stromspitzen(15, 16, 17) zu erkennen und in Abhängigkeit davon die dielektrische Kapazität des Lithium-Ionen-Akkumulators (2) zum Abdecken der Differenz zwischen der Stromanforderung (14) des Elektrogeräts (1) und des vorgegebenen Bemessungsstroms (18) zu nutzen.

5. Batteriemanagementsystem (12) nach Anspruch 4,
**dadurch gekennzeichnet, dass**
das Batteriemanagementsystem (12) dazu ausgelegt ist, vorgegebene Stromverläufe für die unterschiedlichen Arten von Stromspitzen (15, 16, 17) mit der Stromanforderung (14) zu vergleichen und basierend darauf die jeweiligen Arten von Stromspitzen (15, 16, 17) zu erkennen.

6. Batteriemanagementsystem (12) nach einem der vorhergehenden Ansprüche,
**dadurch gekennzeichnet, dass**
das Batteriemanagementsystem (12) dazu ausgelegt ist, in Abhängigkeit von zumindest einer der folgenden Größen die Ausnutzung der dielektrischen Kapazität des Lithium-Ionen-Akkumulators (2) zu steuern:
- einer Temperatur des Lithium-Ionen-Akkumulators (2), insbesondere jeweiliger Zellen (3) des Lithium-Ionen-Akkumulators (2);
- einem Innenwiderstand des Lithium-Ionen-Akkumulators (2), insbesondere von jeweiligen Zellen (3) des Lithium-Ionen-Akkumulators (2);
- eines Ladezustands des Lithium-Ionen-Akkumulators (2), insbesondere von jeweiligen Zellen (3) des Lithium-Ionen-Akkumulators (2);
- eines Gesundheitszustands des Lithium-Ionen-Akkumulators (2), insbesondere von jeweiligen Zellen (3) des Lithium-Ionen-Akkumulators (2).

7. Lithium-Ionen-Akkumulator (2) für ein Elektrogerät (1), insbesondere für ein elektrisches Handwerkzeug oder ein elektrisches Gartengerät, mit einem Batteriemanagementsystem (12) nach einem der vorhergehenden Ansprüche.

8. Elektrogerät (1), insbesondere elektrisches Handwerkzeug oder elektrisches Gartengerät, mit einem Lithium-Ionen-Akkumulator (2) nach Anspruch 7.

9. Verfahren zum Betreiben eines Lithium-Ionen-Akkumulators (2) eines Elektrogeräts (1), insbesondere eines elektrischen Handwerkzeugs oder elektrischen Gartengeräts, bei welchem mittels eines Batteriemanagementsystems (12) nach einem der Ansprüche 1 bis 6 eine Differenz zwischen einer Stromanforderung (13) des Elektrogeräts (1) und eines vorgegebenen Bemessungsstroms (18), welcher einer mittels des Lithium-Ionen-Akkumulators (2) pro Zeiteinheit auf Grund seiner maximal möglichen Reaktionsgeschwindigkeit elektrochemisch bereitstellbaren Ladungsmenge entspricht, bestimmt wird, und ein Ausgangsstrom des Lithium-Ionen-Akkumulators (2) derart gesteuert wird, dass die Differenz unter Ausnutzung einer dielektrischen Kapazität des Lithium-Ionen-Akkumulators (2) insoweit abgedeckt wird, wie dadurch vorgegebene zulässige Betriebszustände des Lithium-Ionen-Akkumulators (2) nicht verlassen werden.

## Claims

1. A battery management system (12) for a lithium ion battery (2) of an electrical appliance (1), in particular of an electrical hand tool or an electrical gardening tool, which is configured to
- determine a difference between a current requirement (14) and a preset measuring current (18), which corresponds to an amount of charge electrochemically providable by means of the lithium ion battery (2) per time unit due to its maximally possible response speed;
- control an output current of the lithium-ion battery (2) such that the difference is covered using a dielectric capacitance of the lithium ion battery (2) insofar as it is thereby not departed from preset acceptable operating states of the lithium ion battery (2).

2. The battery management system (12) according to claim 1,
**characterized in that**
the battery management system (12) is configured to cover the difference considering an actual state of charge of the dielectric capacitance of the lithium ion battery (2).

3. The battery management system (12) according to claim 1 or 2,
**characterized in that**
the battery management system (12) is configured to cover the difference considering a charging behavior of the dielectric capacitance of the lithium ion battery (2).

4. The battery management system (12) according to any one of the preceding claims,
**characterized in that**
the battery management system (12) is configured to recognize different types of current peaks (15, 16, 17) based on the current requirement (14) and to use the dielectric capacitance of the lithium ion battery (2) depending thereon for covering the difference between the current requirement (14) of the electrical appliance (1) and the preset measuring current (18).

5. The battery management system (12) according to claim 4,
**characterized in that**
the battery management system (12) is configured to compare preset current progressions for the different types of current peaks (15, 16, 17) to the current requirement (14) and to recognize the respective types of current peaks (15, 16, 17) based thereon.

6. The battery management system (12) according to any one of the preceding claims,
**characterized in that**
the battery management system (12) is configured to control the use of the dielectric capacitance of the lithium ion battery (2) depending on at least one of the following quantities:
- a temperature of the lithium ion battery (2), in particular of respective cells (3) of the lithium ion battery (2);
- an internal resistance of the lithium ion battery (2), in particular of respective cells (3) of the lithium ion battery (2);
- a state of charge of the lithium ion battery (2), in particular of individual cells (3) of the lithium ion battery (2);
- a state of health of the lithium ion battery (2), in particular of respective cells (3) of the lithium ion battery (2).

7. A lithium ion battery (2) for an electrical appliance (1), in particular for an electrical hand tool or an electrical gardening tool, with a battery management system (12) according to any one of the preceding claims.

8. An electrical appliance (1), in particular electrical hand tool or electrical gardening tool, with a lithium ion battery (2) according to claim 7.

9. A method for operating a lithium ion battery (2) of an electrical appliance (1), in particular of an electrical hand tool or electrical gardening tool, in which a difference between a current requirement (13) of the electrical appliance (1) and a preset measuring current (18), which corresponds to an amount of charge, which can be electrochemically provided by means of the lithium ion battery (2) per time unit due to its maximally possible reaction speed, is determined by means of a battery management system (12) according to any one of claims 1 to 6, and an output current of the lithium ion battery (2) is controlled such that the difference is covered using a dielectric capacitance of the lithium ion battery (2) insofar as it is thereby not departed from preset acceptable operating states of the lithium ion battery (2).

## Revendications

1. Système de gestion de batterie (12) destiné à une batterie à ions lithium (2) d'un appareil électrique (1), en particulier d'un outil à main électrique ou d'un outil de jardinage électrique, lequel système est conçu pour
- déterminer une différence entre un besoin en courant (14) et un courant nominal spécifié (18) qui correspond à une quantité de charge qui peut être fournie par voie électrochimique par unité de temps au moyen de la batterie à ions lithium (2) en raison de sa vitesse de réaction maximale possible ;
- commander un courant de sortie de la batterie à ions lithium (2) de manière que la différence soit couverte à l'aide d'une capacité diélectrique de la batterie à ions lithium (2) dans la mesure où des états de fonctionnement admissibles spécifiés de la batterie à ions lithium batterie (2) ne sont pas ainsi délaissés.

2. Système de gestion de batterie (12) selon la revendication 1,
**caractérisé en ce que**
le système de gestion de batterie (12) est conçu pour couvrir la différence en tenant compte d'un état de charge actuel de la capacité diélectrique de la batterie à ions lithium (2).

3. Système de gestion de batterie (12) selon la revendication 1 ou 2,
**caractérisé en ce que**
le système de gestion de batterie (12) est conçu pour couvrir la différence en tenant compte d'un comportement de charge de la capacité diélectrique de la batterie à ions lithium (2).

4. Système de gestion de batterie (12) selon l'une des revendications précédentes,
**caractérisé en ce que**
le système de gestion de batterie (12) est conçu pour détecter différents types de pointes de courant (15, 16, 17) sur la base du besoin en courant (14) et utiliser, en fonction de ceux-ci, la capacité diélectrique de la batterie à ions lithium (2) pour couvrir la différence entre le besoin en courant (14) de l'appareil électrique (1) et le courant nominal spécifié (18).

5. Système de gestion de batterie (12) selon la revendication 4,
**caractérisé en ce que**
le système de gestion de batterie (12) est conçu pour comparer des courbes de courant spécifiées pour les différents types de pointes de courant (15, 16, 17) au besoin en courant (14) et détecter, sur la base de celui-ci, les types respectifs de pointes de courant (15, 16, 17).

6. Système de gestion de batterie (12) selon l'une des revendications précédentes,
**caractérisé en ce que**
le système de gestion de batterie (12) est conçu pour commander l'utilisation de la capacité diélectrique de la batterie à ions lithium (2) en fonction d'au moins une des grandeurs suivantes :
- une température de la batterie à ions lithium (2), en particulier des cellules respectives (3) de la batterie à ions lithium (2) ;
- une résistance interne de la batterie à ions lithium (2), en particulier des cellules respectives (3) de la batterie à ions lithium (2) ;
- un état de charge de la batterie à ions lithium (2), en particulier des cellules respectives (3) de la batterie à ions lithium (2) ;
- un état de santé de la batterie à ions lithium (2), en particulier de cellules respectives (3) de la batterie à ions lithium (2).

7. Batterie à ions lithium (2) destinée à un appareil électrique (1), notamment un outil électrique à main ou un outil électrique de jardin, ladite batterie comprenant un système de gestion de batterie (12) selon l'une des revendications précédentes.

8. Appareil électrique (1), notamment outil électrique à main ou outil électrique de jardin, comprenant une batterie à ions lithium (2) selon la revendication 7.

9. Procédé de fonctionnement d'une batterie à ions lithium (2) d'un appareil électrique (1), en particulier d'un outil électrique à main ou d'un outil électrique de jardinage, procédé dans lequel, au moyen d'un système de gestion de batterie (12) selon l'une des revendications 1 à 6, une différence est déterminée entre un besoin en courant (13) de l'appareil électrique (1) et un courant nominal spécifié (18) qui correspond à une quantité de charge pouvant être fournie par voie électrochimique par unité de temps au moyen de la batterie à ions lithium (2) en raison de sa vitesse de réaction maximale possible, et un courant de sortie de l'accumulateur à ions lithium (2) est commandé de manière que la différence soit couverte par une capacité diélectrique de l'accumulateur à ions lithium (2) dans la mesure où des états de fonctionnement admissibles spécifiés de l'accumulateur à ions lithium (2) ne sont pas ainsi délaissés.
